Europäisches Patentamt

European Patent Office

Office européen des brevets

(19)

(11) **EP 1 209 184 A1**

(12) **EUROPEAN PATENT APPLICATION**
published in accordance with Art. 158(3) EPC

(43) Date of publication:
**29.05.2002 Bulletin 2002/22**

(21) Application number: **00940831.1**

(22) Date of filing: **26.06.2000**

(51) Int Cl.[7]: **C08G 73/10**, G03F 7/037

(86) International application number:
**PCT/JP00/04173**

(87) International publication number:
**WO 01/00710 (04.01.2001 Gazette 2001/01)**

(84) Designated Contracting States:
**AT BE CH CY DE DK ES FI FR GB GR IE IT LI LU MC NL PT SE**

(30) Priority: **25.06.1999 JP 21767899**

(71) Applicant: **PI R & D Co., Ltd.**
**Yokohama-shi, Kanagawa 236-0002 (JP)**

(72) Inventors:
• **ITATANI, Hiroshi**
**Yokohama-shi, Kanagawa 236-0005 (JP)**

• **MATSUMOTO, Shunichi**
**Kamakura-shi, Kanagawa 248-0034 (JP)**

(74) Representative: **Stuart, Ian Alexander et al**
**MEWBURN ELLIS**
**York House**
**23 Kingsway**
**London WC2B 6HP (GB)**

(54) **PHOTOSENSITIVE LOW-PERMITTIVITY POLYIMIDE AND METHOD OF FORMING POSITIVE POLYIMIDE FILM PATTERN FROM THE SAME**

(57)     Disclosed is a photosensitive, low dielectric polyimide that is applied to uses such as interlayer insulation films of semiconductor devices, for which low dielectric constant is required. The polyimide according to the present invention shows positive-type photosensitivity, is soluble in a solvent, is formed by polycondensation between one or more aromatic tetracarboxylic dianhydrides and mainly one or more aromatic diamines, wherein at least one of the one or more aromatic tetracarboxylic dianhydrides and the one or more diamines contain (a) fluorine atom(s), and/or the diamine(s) is (are) benzidine or (a) derivative(s) thereof and/or (a) fluorene derivative(s), and has a relative dielectric constant of not more than 2.90.

EP 1 209 184 A1

**Description**

Technical Field

The present invention relates to a photosensitive, low dielectric polyimide that is suitably applied to uses such as interlayer insulation films of semiconductor devices, for which low dielectric constant is required, and to a method for forming positive-type pattern of polyimide film using the same.

Background Art

Semiconductor integrated circuits such as large scale integrated circuits (LSI) are consistently promoting the degree of integration, multifunctionality and performance, reflecting the development of fine processing techniques. As a result, electric resistance of the circuits and capacitance between wirings increased, so that not only electric power consumption, but also time lag increased, the latter being a great cause of decrease in the signal speed of the devices. Therefore, it is demanded to decrease the resistance of the circuits and the capacitance between wirings. One of the countermeasures for solving this problem, which is now being tried, is to constitute the vicinities of the wirings with low dielectric interlayer insulation films, thereby decreasing the capacitance and speeding up the operations of the devices. More particularly, it is now tried to replace the silicon dioxide film (dielectric constant: 4.0) used as conventional interlayer insulation films with a low dielectric organic film. However, for interlayer insulation films, not only the dielectric property, but also excellent heat resistance is demanded so as to be able to withstand to the thin film-forming step or post-steps such as connection of the chips and attaching pins in the process of manufacturing substrates to be packaged. Although fluorine-contained resins such as polytetrafluoroethylene are known as low dielectric organic materials, their heat resistance and adhesiveness are insufficient.

Polyimide resins (U.S. Patent No. 3,179,634) are now attracting attention as resin materials having excellent heat resistance which can withstand to the thin film-forming step or post-steps such as connection of the chips and attaching pins in the process of manufacturing substrates to be packaged. The dielectric constants of polyimides are usually about 2.95 to 3.5, and that of Thermit FA-70001 is 2.95 (10 kHz). A polyimide having a lower dielectric constant is demanded.

Photosensitive polyimides having high heat resistances and high insulations are used for passivation of semiconductors, and for constituting circuits in semiconductors. However, in the conventional methods, polyamic acid is used, and the photoresist is of negative-type. Therefore, the patterning sensitivity is lower than that of positive-type photoresist, and the storage stability is low, which are very inconvenient when using the photoresist (Japanese Laid-open Patent Application (Kokai) No. 9-325480). A highly sensitive positive-type photoresist, which also has an improved ease of handling and adhesiveness, had been demanded (Japanese Laid-open Patent Application (Kokai) No. 7-207022).

The present applicant previously developed a photosensitive polyimide composition and filed a patent application directed thereto (WO99/19771). This photosensitive polyimide composition comprises a photoacid generator and a solvent-soluble polyimide which shows positive-type photosensitivity in the presence of the photoacid generator. This photosensitive polyimide composition is soluble in an organic solvent, excels in adhesiveness, heat resistance, mechanical properties and in flexibility, and exhibits the properties of highly sensitive positive-type alkali-soluble photoresist upon irradiation with light.

However, WO99/19771 does not disclose or suggest a method for decreasing dielectric constants of polyimides.

Disclosure of the Invention

Accordingly, an object of the present invention is to provide a photosensitive polyimide having a heat resistance and electric insulation property characteristic to polyimides, and having a low dielectric constant, as well as to provide a method for forming positive-type pattern of polyimide film using the same.

The present inventors intensively studied to discover that the dielectric constant of a polyimide is decreased by the fact that the tetracarboxylic dianhydride and/or diamine constituting the polyimide contain(s) (a) fluorine atom(s), and/or the diamine(s) is(are)benzidine or a derivative thereof and/or a fluorene derivative, thereby completing the present invention.

That is, the present invention provides a photosensitive, low dielectric polyimide which shows positive-type photosensitivity, which is soluble in a solvent, which is formed by polycondensation between one or more aromatic tetracarboxylic dianhydrides and mainly one or more aromatic diamines, at least one of said one or more aromatic tetracarboxylic dianhydrides and said one or more diamines containing (a) fluorine atom(s), and/or said diamine(s) being benzidine or (a) derivative(s) thereof and/or (a) fluorene derivative(s), which polyimide has a relative dielectric constant of not more than 2.90. The present invention also provides a printed board comprising the polyimide according to the above-mentioned polyimide of the present invention, which polyimide is impregnated in glass fibers or Kevler woven fabric and dried to solidify. The present invention further provides a positive-type photosensitive, low dielectric polyimide composition comprising the above-described polyimide according to the present invention, and a photoacid generator. The present invention still further provides a method for preparing a positive-type pattern of polyimide film, comprising adding a photoacid generator to the above-described polyimide according to the present invention, applying the obtained composition on a substrate, irradiating an active light source in a patterned shape, and removing the irradiated regions by development. The present invention still further provides a patterned polyimide film formed by the above-described method according to the present invention.

By the present invention, low dielectric and solvent-soluble polyimide was first provided. Since the polyimide according to the present invention has a low dielectric constant, and has heat resistance and electric insulation performance characteristic to polyimides, they may suitably be applied to uses such as interlayer insulation films in semiconductor devices, for which low dielectric insulation films are desired.

Best Mode for Carrying Out the Invention

The most characteristic feature of the polyimide according to the present invention resides in that the dielectric constant of the polyimide is low. More particularly, the relative dielectric constant of the polyimide according to the present invention is not more than 2.90, preferably not more than 2.70, and more preferably not more than 2.6. The relative dielectric constants of the conventional polyimides are about 2.95 to 3.5, so that the dielectric constant of the polyimide of the present invention is lower than those of the conventional polyimides.

The low dielectric constant of the polyimide of the present invention is brought about by satisfying at least one of the following (1) to (3): (1) at least one of the one or more aromatic tetracarboxylic dianhydrides and one or more diamines which constitute the polyimide contains a fluorine atom; (2) the diamine(s) is(are) benzidine or (a) derivative(s) thereof; and (3) the diamine(s) is(are) (a) fluorene derivative(s), preferably by satisfying not less than two of (1) to (3), and most preferably by satisfying all of (1) to (3).

In cases where the aromatic tetracarboxylic dianhydride contains (a) fluorine atom(s), the hydrogen atom(s) on the aromatic ring (at least one benzene ring or a condensed ring (naphthalene ring or anthracene ring) containing at least one benzene ring, a hetero ring containing a conjugated double bond, or the like) and/or on a moiety such as alkylene group may be substituted directly with (a) fluorine atom(s), or with halogenated lower alkyl or halogenated lower alkoxy, such as trifluoromethyl. In the present specification, the term "lower" means, unless otherwise specified, those having 1 to 6 carbon atoms. About 3 to 12 fluorine atoms are preferably contained in one molecule. A preferred example of the tetracarboxylic dianhydride containing (a) fluorine atom(s) is 4,4'-{2,2,2-trifluoro-1-(trifluoromethyl)ethylidene}bis(1,2-benzenedicarboxylic anhydride) (hereinafter referred to as "6FDA"), although the tetracarboxylic dianhydride containing (a) fluorine atom(s) is not restricted thereto.

In cases where the diamine contains (a) fluorine atom(s), the hydrogen atom(s) on the aromatic ring (at least one benzene ring or a condensed ring (naphthalene ring or anthracene ring) containing at least one benzene ring, a hetero ring containing a conjugated double bond, or the like) and/or on a moiety such as alkylene group may be substituted directly with (a) fluorine atom(s), or with halogenated lower alkyl or halogenated lower alkoxy, such as trifluoromethyl. About 3 to 12 fluorine atoms are preferably contained in one molecule. Preferred examples of diamines containing (a) fluorine atom(s) include 1,1,1,3,3,3-hexafluoro-2,2-bis(4-aminophenyl)propane, 2,2'-trifluoromethyl-4,4'-diaminobiphenyl, 2,2',6,6'-tetratrifluoromethyl-4,4'-diaminobiphenyl, 2,2-bis {4-(4-aminophenoxy)phenyl}hexafluoropropane (hereinafter also referred to as "HFBAPP" for short), although the diamine containing (a) fluorine atom(s) is not restricted to thereto.

Preferred examples of the benzidine derivative which may be employed in the present invention include those wherein totally 1 to 8 hydrogen atoms on the two benzene rings of benzidine is(are) substituted with lower alkyl, lower alkoxy and/or hydroxyl group(s). Those wherein these groups are bound to the carbon atoms neighboring each amino group are particularly preferred. Preferred specific examples include 3,3'-dimethylbenzidine, 3,3'-dimethoxybenzidine and 3,3'-dihydroxybenzidine, but the benzidine derivatives are not restricted to these.

The fluorene derivative which may be employed in the present invention is a molecule that contains at least a fluorene ring and 2 amino groups. Those wherein one or more aromatic amino groups are bound to the fluorene ring are particularly preferred. Preferred specific examples of the fluorene derivatives include 9,9-bis(4-aminophenyl)fluorene (hereinafter also referred to as "FDA") and 9,9-bis(4-aminophenoxyphenyl)fluorene, but the fluorene derivatives are not restricted thereto.

As mentioned above, the low dielectric constant defined in the present invention is attained by incorporating in the polyimide the following: (1) fluorine-containing tetracarboxylic dianhydride and/or fluorine-containing diamine, and/or (2) benzidine or a derivative thereof, and/or (3) a diamino derivative fluorene. The more the contents of (1) to (3), the lower the dielectric constant. Thus, bearing this in mind, the relative dielectric constant defined in the present invention may be easily attained by routine experiments by appropriately adjusting the contents of these components. Usually, the total contents of (1) to (3) based on all monomers constituting the polyimide is about 83 to 16 mol%, preferably about 66 to 33 mol%.

Although at least one of the above-mentioned (1) to (3) is necessary for attaining the low dielectric constant defined in the present invention, to attain excellent heat resistance, electric insulation performance and adhesiveness with substrates, the polyimide of the present invention may preferably be a polyimide copolymer, particularly, a polyimide block copolymer containing a tetracarboxylic dianhydride and/or diamine other than the above-described (1) to (3).

Preferred examples (described in the form of monomer) of the aromatic tetracarboxylic dianhydride other than the above-described (1) include pyromellitic dianhydride, 1,2,3,4-benzenetetracarboxylic dianhydride, 3,4,3',4'-biphenyltetracarboxylic dianhydride, 3,4,3',4'-benzophenonetetracarboxylic dianhydride, 2,3,2',3'-benzophenonetetracarboxylic dianhydride, 2,2-bis(3,4-dicarboxyphenyl)propane dianhydride, 2,2-bis(2,3-dicarboxyphenyl)propane dianhydride, bis(3,4-dicarboxyphenyl)ether dianhydride, bis(2,3-dicarboxyphenyl)ether dianhydride, bis(3,4-dicarboxyphenyl)sulfone dianhydride, bis (2,3-dicarboxyphenyl)sulfone dianhydride, 9,9-bis{4-(3,4-dicarboxyphenoxy)phenyl}fluorene dianhydride, 2,3,3',4'-biphenyl ether tetracarboxylic dianhydride, 1,2,5,6-naphthalenetetracarboxylic dianhydride, 2,3,6,7-naphthalenetetracarboxylic dianhydride, 1,4,5,8-naphthalenetetracarboxylic dianhydride, 3,4,9,10-perylenetetracarboxylic dianhydride, 2,3,5,6-pyridinetetracarboxylic dianhydride, 3,4,3',4'-biphenylsulfonetetracarboxylic dianhydride and bicyclo(2,2,2)-oct-7-ene-2,3,5,6-tetracarboxylic dianhydride.

These aromatic tetracarboxylic dianhydrides may be used individually or in combination.

Especially preferred examples include those which mainly contain, as the aromatic tetracarboxylic dianhydride (s), 6FDA, or 6FDA and 3,4,3',4'-biphenyltetracarboxylic dianhydride and/or 3,4,3',4'-benzophenonetetracarboxylic dianhydride. It should be noted that the term "mainly" used in the present specification and claims mean a content of not less than 50 mol%. In cases where the polyimide contains 6FDA and 3,4,3',4'-biphenyltetracarboxylic dianhydride and/or 3,4,3',4'-benzophenonetetracarboxylic dianhydride, the ratio of contents of these components are not restricted, and the ratio of 6FDA:3,4,3',4'-biphenyltetracarboxylic dianhydride and/or 3,4,3',4'-benzophenonetetracarboxylic dianhydride may preferably be about 1:2 to 2:1 by mole, especially about 1:1.

As the diamine, not less than two of the above-described (1) to (3) are preferably contained. In this case too, the polyimide is also a polyimide copolymer, and is preferably a polyimide block copolymer.

Preferred examples of the diamine other than the above-described (1) to (3) include aromatic diamines such as p-phenylenediamine, m-phenylenediamine, 1,5-diaminonaphthalene, 4,4'- (or 3,4'-, 3,3'- or 2,4'-)diaminodiphenylether, 4,4'- (or 3,3'-)diaminodiphenylsulfone, 4,4'- (or 3,3'-) diaminodiphenylsulfide, 4,4'-benzophenonediamine, 3,3'-benzophenonediamine, 4,4'-di(4-aminophenoxy)phenylsulfone, 4,4'-di(3-aminophenoxy)phenylsulfone, 4,4'-bis (4-aminophenoxy)biphenyl, 1,4-bis(4-aminophenoxy)benzene, 1,3-bis(4-aminophenoxy)benzene, 2,2-bis{4-(4-aminophenoxy)phenyl}propane, 3,3'-dimethyl-4,4'-diaminodiphenylmethane, 3,3',5,5'-tetramethyl-4-4'-diaminodiphenylmethane, 4,4'-di(3-aminophenoxy)phenylsulfone, 3,3'-diaminodiphenylsulfone, 2,2'-bis(4-aminophenyl)propane and 2,2',6,6'-tetramethyl-4,4'-diaminobiphenyl; 2,6-diaminopyridine, 2,4-diaminopyridine and bis(4-aminophenyl-2-propyl)-1,4-benzenne, and diaminobenzoic acid. These diamine compounds may be used individually or in combination.

It is preferred to use a diaminosiloxane as a diamine component because the adhesiveness with the substrate is promoted. The "diaminosiloxane" constituting the polyimide of the present invention means a diamine in which that the moiety constituting the main chain of the polyimide consists essentially of siloxane structure. The number of silicon atoms in the siloxane structure is preferably about 1 to 50. Each silicon atom in the siloxane structure may be substituted with one or two lower alkyl groups and/or one or two lower alkoxy groups. The amino groups may be directly attached to the siloxane structure or may be attached through lower alkylene groups. Further, the diaminosiloxane may contain a structure other than the siloxane structure, especially in the side chains, which structure does not adversely affect the advantageous effects of the present invention. Examples of such a diaminosiloxane include 1,3-bis-(3-aminopropyl) tetramethyldisiloxane (molecular weight: 248.5) and diaminosiloxane whose both ends are amino groups (amine value: 300-500).

In cases where the polyimide contains a diaminosiloxane as the diamine component, the content of the diaminosiloxane in the diamine component is not restricted and usually about 33 to 16 mol% is preferred.

In the polyimide of the present invention, the diamine component also mainly consists of (an) aromatic diamine (s).

In the especially preferred mode of the present invention, FDA; and/or 3,3'-dimethylbenzidine, 3,3'-dimethoxybenzidine, 3,3'-dihydroxybendizine and/or 2,2',6,6'-tetramethyl-4,4'-diaminobiphenyl, which is an aromatic diamine having substituent groups adjacent to the amino groups; and/or (a) diaminosiloxane compound(s), such as 1,3-bis-(3-aminopropyl)tetramethyldisiloxane (molecular weight: 248.5) and diaminosiloxane whose both ends are amino groups (amine value: 300-500), is(are) used. In the present invention, the polyimide preferably contains two or more of these diamines. Preferred examples of the diamine which is used together with these diamines include HFBAPP, 3,4'-diaminodiphenyl ether and diaminobenzoic acid. Polyimide copolymers containing not less than three types of diamines, which are combination of these diamines, are especially preferred because they not only have low dielectric constants, but also have excellent characteristics such as fine processability and adhesiveness.

Polyimides which contain as a diamine component 6FDA and/or 3,3'-dimethylbenzidine, and at least one selected from the group consisting of 2,2-bis{4-(4-ammophenoxy)phenyl}hexafluoropropane, 3,4'- or 4,4'-diaminodiphenylether, 3,3'-dihydroxybenzidine and 3,5-diaminobenzoic acid, are preferred.

The polyimide contained in the composition of the present invention is solvent soluble. Here, the term "solvent soluble" means that the polyimide is dissolved in N-methyl-2-pyrrolidone (NMP) to a concentration of not less than 5% by weight, preferably not less than 10% by weight.

The weight average molecular weight in terms of polystyrene of the polyimide according to the present invention is preferably not less than 25,000, more preferably 30,000 to 400,000. If the weight average molecular weight is within this range, good solvent solubility, film-forming property, film strength and insulation performance may be obtained in addition to low dielectric constant.

The polyimide in the composition according to the present invention may be produced by direct imidation reaction between the aromatic diamine and the aromatic tetracarboxylic dianhydride. In the production of the conventional negative-type polyimide photoresists, a polyamic acid having photoreactive side chains are used. The polyamic acid is easily decomposed at room temperature, so that the storage stability is poor. Further, the photosensitive polyamic acid requires heat treatment at 250 to 350°C so as to carry out imidation reaction. In contrast, the polyimide in the composition according to the present invention is directly produced by the imidation reaction between the aromatic diamine and the aromatic tetracarboxylic dianhydride in solution, but not a polyamic acid, so that the production process thereof is largely different from that of the conventional negative-type polyimides.

The direct imidation reaction between the aromatic diamine and the aromatic tetracarboxylic dianhydride may be carried out using a catalytic system utilizing the following equilibrium reaction between a lactone, base and water.

$$\{lactone\} + \{base) + \{water\} = (acid\}^{+}\{base\}^{-}$$

A polyimide solution may be obtained by using the $\{acid\}^{+}\{base\}^{-}$ system as a catalyst and heating the reaction mixture at 150-220°C, preferably 160-200°C. The water produced by the imidation reaction is eliminated from the reaction system by azeotropic distillation with toluene. When the imidation in the reaction system is completed, $\{acid\}^{+}$ $\{base\}^{-}$ is converted to the lactone and the base, and they lose the catalytic activity and are removed from the reaction system. The polyimide solution produced by this process can be industrially used as it is as a polyimide solution with high purity because the above-mentioned catalytic substances are not contained in the polyimide solution after the reaction.

Examples of the reaction solvent which may be used in the above-mentioned imidation reaction include, in addition to the above-mentioned toluene, N,N-dimethylformamide, N,N-dimethylmethoxyacetamide, N,N-dimethylethoxyacetamide, N-methyl-2-pyrrolidone, N-methylcaprolactam, dimethylsulfoxide, dimethylsulfolane, tetramethylurea and the like. These organic solvents may be used individually or in combination. In the above-described polycondensation reaction, the concentration of the reaction materials is usually 5 to 40% by weight, preferably 10 to 30% by weight.

As the lactone, γ-valerolactone is preferred. As the base, pyridine and/or methylmorpholine is(are) preferred.

The mixing ratio (acid/diamine) between the aromatic acid dianhydride and the aromatic diamine subjected to the imidation reaction is preferably about 1.05 to 0.95 in terms of molar ratio. Further, the concentration of the acid dianhydride based on the total reaction mixture is preferably about 4 to 16% by weight, the concentration of the lactone is preferably about 0.2 to 0.6% by weight, the concentration of the base is preferably about 0.3 to 0.9% by weight, and the concentration of the toluene is preferably about 6 to 15% by weight at the initiation of the reaction. The amount of the lactone used is preferably 0.05 to 0.3 mol based on the acid dianhydride (U.S. Patent No. 5,502,143). The reaction time is not restricted and varies depending on the molecular weight of the polyimide to be produced and the like, and usually about 2 to 10 hours. It is preferred to carry out the reaction under stirring.

It should be noted that the production process *per se* of the polyimide using the binary catalytic system comprising the lactone and the base is known, and described in, for example, U.S. Patent No. 5,502,143.

By carrying out the above-described imidation reaction sequentially in two steps using different acid dianhydrides and/or different diamines, polyimide block copolymers can be produced. By the conventional process for producing polyimide through polyamic acid, only random copolymers can be produced as copolymers. Since polyimide block copolymers can be produced selecting arbitrary acids and/or diamines, desired properties or functions such as adhesiveness, dimensional stability, low dielectric constant and the like can be given to the polyimide. In the composition of the present invention, such a polyimide copolymer may preferably be employed.

A preferred process for producing the polyimide block copolymers include the process wherein a polyimide oligomer is produced using the acid catalyst generated by the above-described lactone and the base, and using either one of the aromatic diamine component or the tetracarboxylic dianhydride in excess, and then the aromatic diamine and/or the tetracarboxylic dianhydride is(are) added (the molar ratio of the total aromatic diamines to the total tetracarboxylic dianhydride is 1.05 to 0.95), thereby carrying out two-step polycondensation.

That is, in the synthesis of the polyimide block copolymer according to the present invention, a tetracarboxylic dianhydride (A1) and an aromatic diamine (B1) are mixed and heated in a solvent to prepare a polyimide oligomer. Then a tetracarboxylic dianhydride (A2) and/or an aromatic diamine (B2) are added. By heating the mixture to polycondense the materials, a polyimide block copolymer $\{(A1\text{-}B1)_m\text{-}(A2\text{-}B2)_n\}_p$ (wherein m, n and p represent integers) in which the molar ratio of the total tetracarboxylic dianhydrides (A1+A2) to the total aromatic diamines (B1+B2) is 1.05 to 0.95 can be obtained. Here, it is necessary to select the combination by which the produced polyimide copolymer is soluble in the solution and does not precipitate. In view of this, 6FDA and BPDA are useful acid dianhydrides. On the other hand, pyromellitic dianhydride often yields insoluble polyimide copolymer.

Polyimide block copolymers have an advantage that the properties may be improved while retaining the properties of the polyimides. That is, polyimide block copolymers have an advantage that improvement of the properties, such as increasing adhesiveness, dimensional stability, chemical resistance, photosensitivity and the like, may be attained by using easily available materials which are industrially produced.

The polyimide according to the present invention may be in the form of solution suited for application on substrates. In this case, as the solvent, a polar solvent such as N-methyl-2-pyrrolidone, dimethylformamide, dimethylacetamide, dimethylsulfoxide, sulfolane, tetramethylurea or the like, which is used as the solvent for the imidation reaction, may be employed. The concentration of the polyimide in the solution may preferably be 5% to 50% by weight, more preferably 10% to 40% by weight. Since the polyimide obtained by the direct imidation using the catalytic system comprising the lactone and the base is obtained in the form of solution in which the polyimide is dissolved in the polar solvent, and since the concentration of the polyimide in the obtained solution is within the preferred range mentioned above, the polyimide solution produced by the above-described process may advantageously be used as it is. If desired, however, the produced polyimide solution may be diluted with a diluent. As the diluent, a solvent which does not largely decrease the solubility, such as dioxane, dioxolane, γ-butyrolactone, cyclohexanone, propylene glycol monomethyl ether acetate, methyl lactate, anisole, ethyl acetate or the like may be employed, although the diluent is not restricted to these.

The polyimide solution thus prepared have good stability in storage. In a closed container, it can be stored stably at room temperature for several months to several years.

By applying the polyimide copolymer according to the present invention dissolved in a solvent on glass fibers, Kevler woven fabric, ceramic fiber substrate or the like by dipping method or the like, and drying the solution, a substrate for composite printed wiring board or a flexible film substrate can be obtained. The apparatus for carrying out the drying is not restricted, and infrared heaters are useful. In cases where the thickness of the polyimide copolymer resin applied is not more than 30 μm drying at 90°C for 1 hour and at 180°C for 1 hour, totally two hours, is sufficient, In cases where the thickness of the film is not less than 50 μm, a polyimide copolymer film from which the solvent is completely eliminated may be obtained by drying at 90°C for 1 hour, at 140°C for 1 hour, at 180°C for 2-3 hours, and then at 240°C for 1-2 hours, totally about 5-7 hours.

The polyimide copolymer according to the present invention is a thermoset resin having a low dielectric constant and low dielectric loss tangent, and excels in ease of handling, adhesiveness with metal or the like, heat resistance, chemical resistance, and inflammability, and may suitably be used in laminate sheets, metal-lined laminate sheets and the like.

Examples of the use of the polyimide copolymer according to the present invention when used as an interlayer insulation film include interlayer insulation films of multilayer wirings in semiconductors, interlayer insulation films of rigid plates of multilayer printed board, flexographic printing plates or the like, and interlayer insulation films of packages or MCM substrates. Further, by flowing a varnish of the polyimide on a substrate, and heating the vanish to dry, a dry film of the polyimide having a thickness of several tens to several hundreds micrometers may be obtained. Such a dry film may be applied to other uses, for example, passivation films (stress buffer films) of semiconductors, α-ray-blocking films, cover lay films of flexographic printing plates, overcoats of flexographic printing plates or the like. Examples of the uses of the polyimide copolymer according to the present invention other than the above-mentioned uses include adhesive for die bonding, adhesive tape for lead-on-chips (LOC), tape for fixing lead frames and adhesive for multilayer lead frames.

The low dielectric, solvent-soluble polyimide copolymer according to the present invention exhibits excellent photosensitivity. Thus, the polyimide gives positive-type relief patterns having low dielectric constant, excellent heat resistance, adhesiveness and chemical resistance. The solvent-soluble polyimide block copolymer gives positive-type relief patterns by irradiation with ultraviolet or visible light in the presence of a photoacid generator, and by developing the resultant with an alkaline developing solution to dissolve the light-irradiated regions.

The sensitivity and resolution by the light irradiation of the polyimide copolymer according to the present invention is influenced by the types of the aromatic diamines constituting the polyimide copolymer. 3,3-dimethylbenzidine which is an aromatic diamine having a configurational distortion, and FDA which is three-dimensionally voluminous gives positive-type photosensitive patterns with high sensitivity. The low dielectric polyimide copolymer may be used as a photolithography material simultaneously having high sensitivity and high resolution. In the present specification, in both cases where the polyimide is used as it is as an insulation film or dielectric layer in a semiconductor device or the like, and where the polyimide is used as a photoresist for selective etching of the substrate, polyimide is called "photolithography material". However, even in cases where the patterned polyimide film after development is used as an insulation film or a dielectric layer and not used for the selective etching of the substrate, the polyimide may also be called "photoresist" or "resist" for convenience.

As the developing solution used for developing the patterns of the positive-type photosensitive polyimide copolymer of the present invention, alkaline developing solutions are used, preferably those containing aminoethanol.

The amount of the photoacid generator used for forming the pattern is preferably 5 to 50% by weight, more preferably 5 to 20% by weight based on the polyimide. When the thickness of the polyimide film on the substrate is small, the amount of the photoacid generator is preferably small accordingly.

As the photoacid generator. the following compounds may be employed. Examples of the photosensitive quinone diazide compounds include esters of 1,2-naphthoquinone-2-diazide-5-sulfonic acid and 1,2-naphthoquinone-2-diazide-4-sulfonic acid, the counterparts of the esters being low molecular aromatic hydroxyl compounds such as 2,3,4-trihydroxybenzophenone, 1,3,5-trihydroxybenzene, 2-methylphenol; 4-methylphenol and 4,4'-hydroxy-propane. These compounds may be added in an amount of 0.1 to 0.5 based on the weight of the polyimide resin.

Examples of the onium salts which may be used as the photoacid generator include aryl diazonium salts such as 4(N-phenyl)aminophenyl diazonium salt; diaryl halonium salts such as diphenyl iodonium salt; triphenyl sulfonium salts such as bis{4-(diphenylsulfonio)phenyl} sulfide, and bis-hexafluoroantimonate. These compounds may be added in an amount of 0.1 to 0.5 based on the weight of the polyimide resin.

The patterning according to the present invention may be carried out by irradiating the positive-type photosensitive polyimide copolymer according to the present invention in the presence of the photoacid generator which generates an acid upon irradiation, and by removing the irradiated regions with an alkaline developing solution. By using a far ultraviolet ray, especially one having a wavelength of 365 nm or less, as the exposure energy, positive-type photosensitive patterns with sizes of less than 1 μm may also be formed.

The present invention further provides a method for forming a pattern of positive-type photosensitive polyimide copolymer, which method comprises the steps of 1) forming a photosensitive layer containing as a main component the above-described polyimide composition; 2) irradiating the polyimide composition with an exposure energy; 3) heat-treating the photosensitive layer; and 4) developing the photosensitive layer after exposure to selectively remove the prescribed regions in the photosensitive layer.

A method for forming a pattern using the low dielectric, positive-type photosensitive polyimide copolymer according to the present invention will now be described.

A varnish containing the photoresist dissolved in the above-mentioned organic solvent is applied on a prescribed substrate by roll coating method, dipping method or the like, and then dried at a temperature of not higher than 150°C, preferably at 70 to 100°C to form a photoresist film. Examples of the substrate employed here include copper foil, aluminum foil, copper-lined laminate sheet, silicon wafers, blank masks, and III-V group compound semiconductor wafers such as GaAs and AlGaAs. Alternatively, chromium- or chromium oxide-deposited masks, aluminum-deposited substrates, IBPSG-coated substrates, PSG-coated substrates, SOG-coated substrates, and carbon film sputter substrates may also be used.

Exposure to an actinic ray is carried out through a mask, or the surface of the photosensitive polyimide film may also be directly irradiated with an actinic ray. Examples of the actinic ray include various UVs such as i-line, h-line and g-line of low pressure mercury lamp, light from xenon lamp, and far ultraviolet rays such as excimer laser beams from KrF, ArF or the like, X-ray, electron beam, gamma ray, neutron ray and ion beams.

The photoresist film is then optionally heated (baked) at 50°C to 150°C, preferably 60°C to 120°C by heating on a hot plate or in an oven, or by irradiation with infrared light. If the temperature of the heat treatment is lower than 50°C, the acid generated by the photoacid generator may not sufficiently react with the compound having the substituent groups decomposed by the acid. On the other hand, if the temperature is higher than 120°C, the exposed area and the non-exposed area of the photoresist film may be excessively decomposed or excessively cured. By the above-mentioned baking, in the exposed area of the photoresist film, the acid generated by the exposure acts as a catalyst and reacts with the compound having substituent groups to cleave the imide bond. That is, the imide group decomposed by the acid is converted to an alkaline-soluble compound by decomposition of the imide group. In some cases, by leaving the photoresist film at room temperature for a long time, the same effect obtained by the above-mentioned post-baking may be obtained.

The photoresist film after baking is then subjected to development with an alkaline developer by immersion method or spray method to selectively dissolve and remove the exposed areas of the photoresist film, thereby obtaining the desired pattern. Examples of the alkaline solution used as the developer include inorganic aqueous alkaline solutions such as aqueous solutions of sodium hydroxide, sodium carbonate and sodium metasilicate, and organic aqueous alkaline solutions such as aqueous solutions of tetramethylammonium hydroxide, trimethylhydroxyammonium hydroxide and ethanolamine, as well as these aqueous solutions to which one or more alcohols, surfactants or the like are added.

Since the low dielectric, positive-type photosensitive polyimide copolymer composition according to the present invention has very high solubility in alkali, the polyimide film pattern is free from cracks and jagging, and the pattern is not collapsed. Further, the pattern can be formed with a high reproducibility. In addition, the obtained pattern has a very high resolution. Therefore, by using the resist pattern as an etching mask for dry etching, very fine pattern with a size of less than 1 µm can be accurately transcribed to the exposed substrate. One or more steps other than those mentioned above may be added without any problems. For example, a step of forming a flat layer used as the bed layer of the photoresist film, a pre-treatment step for improving adhesiveness between the photoresist film and the bed layer, a rinsing step for removing the developer with water or the like after development, a step of re-irradiation of UV before dry etching and/or the like may be optionally carried out.

As mentioned above, in the preferred mode of the low dielectric, positive-type photosensitive polyimide copolymer according to the present invention; a compound such as 6FDA or FDA is incorporated in the main chain of the polymer, so that the polymer has a high transparency.

Thus, by forming a resist film on a substrate by applying the photosensitive composition according to the present invention on a substrate, irradiation of actinic ray (exposure), heating (baking) and by development with an alkali, fine resist pattern with good pattern profile can be formed. In turn, by conducting dry etching on the substrate using the resist pattern as a mask, the pattern can be accurately transcribed to the substrate without sagging or the like of the pattern.

Examples of the diluents which may be used for diluting the low dielectric, positive-type photosensitive polyimide copolymer according to the present invention include dioxane, dioxolan, γ-butyrolactone, cyclohexanone, propylene glycol monomethyl ether acetate, methyl lactate, anisole and ethyl acetate, but the diluent is not restricted thereto.

The sensitivity of the pattern resolution may be increased by giving a photosensitizer to the photosensitive polyimide of the present invention. Although not restricted, examples of the photosensitizer include Michler's ketone, benzoin ether, 2-methylanthraquinone, benzophenone, benzoic acid esters and the like. In an especially preferred mode, isopropyl benzoate and/or tertiary butyl benzoate and/or phenyl benzoate may be used as (a) photosensitizer (s) together with the above-mentioned photoacid generator, because these compounds effectively work. The content of the photosensitizer is not restricted, and usually an amount of about 5 to 10% by weight based on the total weight of the composition is preferred.

Further, modifiers which are added to the ordinary photosensitive polyimides, such as coupling agents, plasticizers, film-forming resins, surfactants, stabilizers, spectrum sensitivity-adjusters and the like may be added.

After the exposure, the irradiated regions of the photoresist layer may be removed by treating the photoresist layer with an alkaline aqueous solution as a developing solution. The treatment may be carried out by, for example, dipping the photoresist layer or spraying the developer under pressure to the photoresist layer so as to dissolve the exposed regions thereof.

The development time varies depending on the energy of exposure, strength of the developer, manner of development, preheating temperature, temperature of the treatment with the developer and the like. Usually, with the development by dipping, the development time is about 1 to 10 minutes, and with the development by spraying, the development time is usually about 0.5 to 5 minutes. The development is stopped by, for example, dipping the developed layer in an inactive solvent such as isopropanol or deionized water, or by spraying such a solvent.

By using the low dielectric, positive-type photosensitive polyimide copolymer according to the present invention, polyimide coating layers having a layer thickness of 1 to 50 µm, and relief structures having sharp edges may be formed.

Since the low dielectric, positive-type photosensitive polyimide copolymer of the present invention is composed of complete linear polyimide, it is not changed in water or heating, and its storage stability is good. Therefore, it can be used as photosensitive films. Further, after forming the pattern by development, unlike the polyamic acid molecules, the postbake at 250 to 350°C is not necessary, and only drying under heat at 150 to 250°C to evaporate the solvent is carried out. Further, the polyimide film after forming the pattern is tough, resistant to high temperature and excellent in mechanical properties.

The resolution and photosensitivity, as well as the heat resistance, chemical resistance and mechanical strength, of the low dielectric, positive-type photosensitive polyimide of the present invention, are variable depending on the molecular weight and the molecular weight distribution. There is a tendency that the larger the molecular weight and the smaller the imide group content, the longer the development time and the dipping time in the alkali solution. As for heat resistance, chemical resistance and mechanical strength, polyimides having average molecular weights in terms of polystyrene of 30,000 to 400,000, preferably 30,000 to 100,000 give good results.

Examples

The present invention will now be described in more detail by way of examples thereof.

Since characteristic low dielectric, photosensitive polyimides are obtained by various combinations of acid dianhydrides and aromatic diamines, the present invention is not restricted to these examples.

Example 1

To a 500 ml three-necked separable flask equipped with a stainless steel anchor agitator, a condenser comprising a trap and a cooling tube having balls and mounted on the trap was attached.

To this flask, 23.54 g (0.08 mol) of 3,3',4,4'-biphenyltetracarboxylic dianhydride (hereinafter referred to as "BPDA" for short, commercial product of UBE INDUSTRIES, LTD), 33.68 g (0,04 mol) of diaminosiloxane compound (hereinafter referred to as "diaminosiloxane" for short, commercial product of Shinetsu Chemical Co., Ltd.) (amine value: 421), 1.6 g (0.016 mol) of $\gamma$-valerolactone, 2.6 g (0.032 mol) of pyridine, 200 g of N-methylpyrrolidone (hereinafter referred to as "NMP" for short) and 100 g of toluene were added. The mixture was heated under stirring at 180 rpm under nitrogen atmosphere at 180°C for 1.0 hour, and then cooled in the air for 30 minutes. Toluene-water distillate in an amount of 15 ml was removed from the reaction system. To the resulting mixture, 35.54 g (0.08 mol) of 4,4'-{2,2; 2-trifluoro-1-(trifluoromethyl)ethylidene} bis(1,2-benzenedicarboxylic anhydride) (commercial product of Hoechst-Celanese, hereinafter referred to as "6FDA" for short), 13.94 g (0.04 mol) of 9,9-bis(4-aminophenyl)fluorene (commercial product of Wakayama Seika Co., Ltd., hereinafter referred to as "FDA" for short), 8.49 g (0.04 mol) of 3,3'-dimethylbenzidine (commercial product of Wakayama Seika Co., Ltd.), 20.74 g (0.04 mol) of 2,2-bis{4-(4-aminophenoxy)phenyl} hexafluoropropane (commercial product of Wakayama Seika Co., Ltd., hereinafter referred to as "HFBAPP" for short), 190 g of NMP and 50 g of toluene were added. After stirring the mixture at room temperature for 1 hour, the mixture was heated to 180°C and stirred at 180 rpm for 4 hours and 50 minutes. During the reactions, toluene-water azeotrope was removed. The mixture was then allowed to react at 180°C, 100 rpm for 50 minutes.

The polymer concentration of the polyimide copolymer solution thus obtained was 25% by weight. The polyimide copolymer solution was filtered through a 1 $\mu$m filter. The molecular weight of this polyimide copolymer was measured by high performance liquid chromatography (commercial product of Tosoh Corporation). The molecular weights based on polystyrene were: Most Frequent Molecular Weight (M): 64,400, Number Average Molecular Weight (Mn): 32,800; Weight Average Molecular Weight (Mw): 75,400; Z Average Molecular Weight (Mz): 139,400, Mw/Mn=2.30, Mz/Mn=4.22.

The polyimide copolymer was flowed on a copper foil, and dried at 90°C for 30 minutes and at 200°C for 1 hour in an infrared drier, followed by measurement of infrared absorption spectrum with FT-IR infrared spectrophotometer (Perkin-Elmer, Spectrum One). The absorptions by polyimide at 1774 cm$^{-1}$ and at 1715 cm$^{-1}$ were prominently observed, and absorption by polyamic acid was not observed at all.

The above-described polyimide copolymer solution (25% by weight) was flowed on a glass plate using a doctor knife, and the solution was dried at 90°C for 1 hour in an infrared drier. The obtained polyimide film was peeled off from the glass plate and clipped on a metal frame (12 cm x 17 cm), followed by heating the film at 200°C for 1 hour to dry it in an infrared drier. The thickness of this polyimide copolymer film was 40 to 50 $\mu$m. This polyimide copolymer film was cut into pieces with a size of about 10 mm x 10 mm, and the relative dielectric constant of the film was measured using HP4211A commercially available from Hewlett-Packard. The sample was sandwiched between electrodes on its upper and lower surfaces, and the frequency was changed from 1.8 GHz to 1 MHz, during which capacitance at 5 or 6 points was measured, thereby determining relative dielectric constant. The experimental error in this experiment for measuring relative dielectric constant was within 0.07.

$$\text{Equation:} \qquad C = \varepsilon(A/t)$$

wherein

  C: capacitance (F)
  A: area of electrode (m$^2$)
  t: thickness of sample (m)
  $\varepsilon$: dielectric constant (F/m)

The relative dielectric constant of the polyimide copolymer film prepared in the above-described experiment, which was measured by the above-described method, was 2.61. The thickness of the sample film was 31 $\mu$m.

Preparation of Photoresist Composition

Twelve grams aliquot of the polyimide copolymer solution (25% by weight) prepared by the method described above was taken (in this case, the content of the polyimide copolymer resin component was 3 g), and 0.45 g (15% by weight based on the polyimide resin) of an ester (NT-200, commercial product of Toyo Gosei Co., Ltd.) between 2,3,4-trihydroxybenzophenone and 6-diazo-5,6-dihydro-5-oxonaphthalene-1-sulfonic acid and 0.21 g (7% by weight based on the polyimide resin) of isopropyl benzoate were added thereto.

The photoresist composition was applied on the surface of a surface-treated copper foil having a diameter of 5 cm (commercial product of Mitsui Metal and Mining Co., Ltd.; thickness 18 $\mu$m) by spin-coating method, and dried by an infrared dryer at 90$^\circ$C for 10 minutes. The thickness of the photoresist film was about 10 $\mu$m.

On this photoresist coating film, a test pattern (through holes and line-and-space pattern having diameters and widths of 10, 15, 20, 25, ---, and 200 $\mu$m, respectively) for positive-type photomask was placed, and the photoresist film was irradiated at a dose of exposure at which images are obtained using 2 kW extra-high pressure mercury lamp apparatus (JP-2000G, commercial product of Oak Seisakusho). The samples irradiated at a dose of exposure of 1000 mJ and 2000 mJ, respectively, were developed with a developer (the developer was a mixture of 30 g of aminoethanol, 30 g of N-methylpyrrolidone and 30 g of water). The sample irradiated at a dose of exposure of 1000 mJ was dipped in the developer at 43$^\circ$C for 10 minutes, and that irradiated at a dose of exposure of 2000 mJ was dipped in the developer for 7 minutes under the same conditions. The samples were washed with deionized water and dried with an infrared lamp, followed by observation of the resolution. The thickness of the polyimide coating films after drying at 90$^\circ$C for 30 minutes and at 180$^\circ$C for 30 minutes was about 9 $\mu$m.

As for the through hole patterns in the polyimide copolymer coating film, formation of through holes having sharp and circular sections having a diameter of 15 $\mu$m was confirmed. As for the line-and-space pattern, formation of images of lines having a width of 10 $\mu$m was confirmed.

Example 2

Polyimide copolymer was synthesized in the same manner as in Example 1.

To the flask, 8.83 g (0.03 mol) of BPDA, 8.78 g (0.01 mol) of diaminosiloxane, 1,1 g (0.014 mol) of pyridine, 0.7 g (0.007 mol) of valerolactone, 100 g of NMP and 30 g of toluene were added. After stirring the mixture at room temperature for 1 hour at 180 rpm under nitrogen atmosphere, the mixture was heated to 180$^\circ$C and stirred at 180 rpm for 1 hour. After cooling the mixture to room temperature, 17.77 g (0.04 mol) of 6FDA, 6.97 g (0.02 mol) of FDA, 10.37 g (0.02 mol) of HFBAPP, 4.25 g (0.02 mol) of 3,3'-dimethylbenzidine, 178 g of NMP and 20 g of toluene were added. After stirring the mixture at room temperature for 1 hour under nitrogen atmosphere, the mixture was heated to 180$^\circ$C and stirred at 180 rpm for 5 hours. During the reactions, toluene-water azeotrope was removed.

The polymer resin concentration of the polyimide copolymer solution thus obtained was 25% by weight. The molecular weight distribution and the relative dielectric constant of this polyimide copolymer were measured, which are shown in Table 1.

Preparation of Photoresist Composition

Twelve grams aliquot of the polyimide copolymer solution (25% by weight) prepared by the method described above was taken (in this case, the content of the polyimide copolymer resin component was 3 g), and 0.06 g (20% by weight based on the polyimide resin) of NT-200 was added thereto.

The photoresist composition was applied on the surface of a surface-treated copper foil having a diameter of 5 cm (commercial product of Mitsui Metal and Mining Co., Ltd.: thickness 18 $\mu$m) by spin-coating method, and dried by an infrared dryer at 90$^\circ$C for 10 minutes. The thickness of the photoresist film was about 10 $\mu$m.

On this photoresist coating film, a test pattern for positive-type photomask was placed, and the photoresist film was irradiated at a dose of exposure at which images are obtained using 2 kW extra-high pressure mercury lamp apparatus. A sample irradiated at a dose of exposure of 1000 mJ was developed with a developer (the developer was a mixture of 30 g of aminoethanol, 30 g of N-methylpyrrolidone and 30 g of water). The sample was dipped in the developer at 43$^\circ$C for 9 minutes, and washed with deionized water. The sample was dried with an infrared lamp and the resolution was observed. The thickness of the polyimide coating film after drying at 90$^\circ$C for 30 minutes and at 180$^\circ$C for 30 minutes was about 9 $\mu$m.

As for the through hole patterns in the polyimide copolymer coating film, formation of through holes having sharp and circular sections having a diameter of 15 $\mu$m was confirmed. As for the line-and-space pattern, formation of images of lines having a width of 10 $\mu$m was confirmed.

Example 3

Polyimide copolymer was synthesized in the same manner as in Example 1.

To the flask, 23.54 g (0.08 mol) of BPDA, 33.68 g (0.04 mol) of diaminosiloxane, 2.6 g (0.032 mol) of pyridine, 1.6 g (0.016 mol) of valerolactone, 200 g of NMP and 100 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 35.54 g (0.08 mol) of 6FDA, 16.98 g (0.08 mol) of 3,3'-dimethylbenzidine, 13.94 g (0.04 mol) of FDA, 154 g of NMP and 40 g of toluene were added. After stirring the mixture at room temperature for 1 hour under nitrogen atmosphere, the mixture was heated to 180°C and stirred at 180 rpm for 3 hours and 5 minutes. The mixture was then allowed to react at 100 rpm for 1 hour. During the reactions, toluene-water azeotrope was removed.

The polymer resin concentration of the polyimide copolymer solution thus obtained was 25% by weight. The molecular weight distribution and the relative dielectric constant of this polyimide copolymer were measured, which are shown in Table 1.

Preparation of Photoresist Composition

A photoresist film was prepared as in Example 1.

On this photoresist coating film, a test pattern for positive-type photomask was placed, and the photoresist film was irradiated at a dose of exposure at which images are obtained. A sample irradiated at a dose of exposure of 1000 mJ was developed with the developer used in Example 1. The sample was dipped in the developer at 43°C for 4 minutes and 13 seconds, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 4

Polyimide copolymer was synthesized in the same manner as in Example 1.

To the flask, 23.54 g (0.08 mol) of BPDA, 33.68 g (0.04 mol) of diaminosiloxane, 2.6 g (0.032 mol) of pyridine, 1.6 g (0.016 mol) of valerolactone, 200 g of NMP and 100 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 35.54 g (0.08 mol) of 6FDA, 8.49 g (0.04 mol) of 3,3'-dimethylbenzidine, 27.88 g (0.08 mol) of FDA, 170 g of NMP and 40 g of toluene were added. After stirring the mixture at room temperature for 1 hour under nitrogen atmosphere, the mixture was heated to 180°C and stirred at 180 rpm for 3 hours and 5 minutes, and then at 180°C, 100 rpm for 1 hour. During the reactions, toluene-water azeotrope was removed.

The polymer resin concentration of the polyimide copolymer solution thus obtained was 25% by weight. The molecular weight distribution and the relative dielectric constant of this polyimide copolymer were measured, which are shown in Table 1.

Preparation of Photoresist Composition

A photoresist film was prepared as in Example 1. Twelve grams aliquot of the polyimide copolymer solution (25% by weight) prepared by the method described above was taken (in this case, the content of the polyimide copolymer resin component was 3 g), and 0.60 g (20% by weight based on the polyimide resin) of NT-200 was added thereto.

On this photoresist coating film, a test pattern for positive-type photomask was placed, and the photoresist film was irradiated at a dose of exposure at which images are obtained. A sample irradiated at a dose of exposure of 1000 mJ was developed with the developer used in Example 1. The sample was dipped in the developer at 50°C for 10 minutes, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 5

Polyimide copolymer was synthesized in the same manner as in Example 1.

To the flask, 5.88 g (0.02 mol) of BPDA, 8.78 g (0.01 mol) of diaminosiloxane, 0,64 g (0.008 mol) of pyridine, 0.4 g (0.004 mol) of valerolactone, 80 g of NMP and 50 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 8.89 g (0.02 mol) of 6FDA, 10.37 g (0.02 mol) of HFBAPP, 2.12 g (0.01 mol) of 3,3'-dimethylbenzidine and 58 g of NMP were added. After stirring the mixture at room temperature for 1 hour under nitrogen atmosphere, the mixture was heated to 180°C and stirred at 180 rpm for 2 hours and 35 minutes. During the reactions, toluene-water azeotrope was removed.

The polymer resin concentration of the polyimide copolymer solution thus obtained was 20% by weight. The molecular weight distribution and the relative dielectric constant of this polyimide copolymer were measured, which are shown in Table 1.

Preparation of Photoresist Composition

A photoresist film was prepared as in Example 1.

On this photoresist coating film, a test pattern for positive-type photomask was placed, and the photoresist film was irradiated at a dose of exposure at which images are obtained. A sample irradiated at a dose of exposure of 2000 mJ was developed with the developer used in Example 1. The sample was dipped in the developer at 46°C for 9 minutes, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 6

Polyimide copolymer was synthesized in the same manner as in Example 1.

To the flask, 5.88 g (0.02 mol) of BPDA, 8.78 g (0.01 mol) of diaminosiloxane, 0.64 g (0.008 mol) of pyridine, 0.4 g (0.004 mol) of valerolactone, 80 g of NMP and 50 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 8.89 g (0.02 mol) of 6FDA, 10.37 g (0.02 mol) of HFBAPP, 2.07 g (0.01 mol) of 4,4'-diaminodiphenyl ether and 58 g of NMP were added. After stirring the mixture at room temperature for 1 hour under nitrogen atmosphere, the mixture was heated to 180°C and stirred at 180 rpm for 2 hours and 30 minutes. During the reactions, toluene-water azeotrope was removed.

The polymer resin concentration of the polyimide copolymer solution thus obtained was 20% by weight. The molecular weight distribution and the relative dielectric constant of this polyimide copolymer were measured, which are shown in Table 1.

Preparation of Photoresist Composition

A photoresist film was prepared as in Example 1.

On this photoresist coating film, a test pattern for positive-type photomask was placed, and the photoresist film was irradiated at a dose of exposure at which images are obtained. A sample irradiated at a dose of exposure of 1500 mJ was developed with the developer used in Example 1. The sample was dipped in the developer at 43°C for 5 minutes, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 7

Polyimide copolymer was synthesized in the same manner as in Example 1.

To the flask, 5.88 g (0.02 mol) of BPDA, 8.78 g (0.01 mol) of diaminosiloxane, 0.64 g (0.008 mol) of pyridine, 0.4 g (0.004 mol) of valerolactone, 80 g ofNMP and 50 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 8.89 g (0.02 mol) of 6FDA, 10.37 g (0.02 mol) of HFBAPP, 10.37 g (0.01 mol) of bis-2-(4-aminophenyl-2-propyl)-1,4-benzene and 64 g of NMP were added. After stirring the mixture at room temperature for 1 hour under nitrogen atmosphere, the mixture was heated to l80°C and stirred at 180 rpm for 2 hours and 30 minutes. During the reactions, toluene-water azeotrope was removed.

The polymer resin concentration of the polyimidc copolymer solution thus obtained was 20% by weight. The molecular weight distribution and the relative dielectric constant of this polyimide copolymer were measured, which are shown in Table 1.

Preparation of Photoresist Composition

A photoresist film was prepared as in Example 1.

On this photoresist coating film, a test pattern for positive-type photomask was placed, and the photoresist film was irradiated at a dose of exposure at which images are obtained. A sample irradiated at a dose of exposure of 2000 mJ was developed with the developer used in Example 1. The sample was dipped in the developer at 46°C for 9 minutes, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 8

Polyimide copolymer was synthesized in the same manner as in Example 1.

To the flask, 6.44 g (0.02 mol) of 3,3',4,4'-benzophenonetetracarboxylic dianhydride, 8.42 g (0.01 mol) of diaminosiloxane (amine value: 421), 0.64 g (0.008 mol) of pyridine, 0.4 g (0.004 mol) of valerolactone, 70 g of NMP and 40 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 8.89 g (0.02 mol) of 6FDA, 2.12 g (0.01 mol) of 3,3'-dimethylbenzidine, 10.37 g (0.02 mol) of HFBAPP, 64 g of NMP and 20 g of toluene were added. After stirring the mixture at room temperature for 1 hour under nitrogen atmosphere, the mixture was heated to 180°C and stirred at 180 rpm for 3 hours and 45 minutes. During the reactions, toluene-water azeotrope was removed.

The polymer resin concentration of the polyimide copolymer solution thus obtained was 20% by weight. The molecular weight distribution and the relative dielectric constant of this polyimide copolymer were measured, which are shown in Table 1.

Preparation of Photoresist Composition

A photoresist film was prepared as in Example 1. Based on the polyimide copolymer, 15% by weight of NT-200 and 7% by weight of isopropyl benzoate were added.

On this photoresist coating film, a test pattern for positive-type photomask was placed, and the photoresist film was irradiated at a dose of exposure at which images are obtained. A sample irradiated at a dose of exposure of 1000 mJ was developed with the developer used in Example 1. The sample was dipped in the developer at 46°C for 6 minutes, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 9

Polyimide copolymer was synthesized in the same manner as in Example 1.

To the flask, 11.77 g (0.04 mol) of BPDA, 17.56 g (0.02 mol) of diaminosiloxane, 1.3 g (0.016 mol) of pyridine, 0.8 g (0.008 mol) of valerolactone, 100 g of NMP and 50 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 12.77 g (0.04 mol) of 6FDA, 10.37 g (0.02 mol) of HFBAPP, 6.40 g (0.02 mol) of di(2,2'-trifluoromethyl)benzidine, 6.97 g (0.02 mol) of FDA, 104 g of NMP and 20 g of toluene were added. After stirring the mixture at room temperature for 1 hour under nitrogen atmosphere, the mixture was heated to 180°C and stirred at 180 rpm for 1 hour and 30 minutes. During the reactions, toluene-water azeotrope was removed.

The polymer resin concentration of the polyimide copolymer solution thus obtained was 25% by weight. The molecular weight distribution and the relative dielectric constant of this polyimide copolymer were measured, which are shown in Table 1.

Preparation of Photoresist Composition

Fifteen grams aliquot of the polyimide copolymer solution (25% by weight) prepared by the method described above was taken (in this case, the content of the polyimide copolymer resin component was 3 g), and 0.45 g (15% by weight based on the polyimide resin) of NT-200 was added thereto.

The photoresist composition was applied on the surface of a surface-treated copper foil having a diameter of 5 cm (commercial product of Mitsui Metal and Mining Co., Ltd.: thickness 18 $\mu$m) by spin-coating method, and dried by an infrared dryer at 90°C for 10 minutes. The thickness of the photoresist film was about 10 $\mu$m.

As in Example I, the photoresist film was irradiated at a dose of exposure at which images are obtained. A sample irradiated at a dose of exposure of 1000 mJ was developed with the developer used in Example 1. The sample was dipped in the developer at 40°C for 4 minutes and 11 seconds, and washed with deionized water. The sample was dried with an infrared lamp and the resolution was observed. As for the through hole patterns in the polyimide copolymer coating film, formation of through holes having sharp and circular sections having a diameter of 15 $\mu$m was confirmed. As for the line-and-space pattern, formation of images of lines having a width of 15 $\mu$m was confirmed.

Example 10

To a 500 ml three-necked separable flask equipped with a stainless steel anchor agitator, a condenser comprising a trap and a cooling tube having balls and mounted on the trap was attached.

To the flask, 39.98 g (0.09 mol) of 6FDA, 10.46 g (0.03 mol) of FDA, 1.0 g (0.01 mol) of δ-valerolactone, 1.6 g (0.02 mol) of pyridine, 150 g of NMP and 30 g of toluene were added. The mixture was stirred at 180 rpm under nitrogen atmosphere at 180°C for 1.0 hour, and the mixture was cooled in the air for 30 minutes. Toluene-water distillate in an amount of 15 ml was removed from the reaction system. To the mixture, 6.49 g (0.03 mol) of 3,3'-dihydroxybenzidine, 15.56 g (0.03 mol) of HHFBAPP, 127 g of NMP and 20 g of toluene were added. After stirring the mixture at room temperature for 1 hour under nitrogen atmosphere, the mixture was heated to 180°C and stirred at 180 rpm for 1 hour and 40 minutes. During the reactions, toluene-water azeotrope was removed.

The polymer concentration of the polyimide copolymer solution thus obtained was 20% by weight. The polyimide copolymer solution was filtered through a 1 $\mu$m filter. The molecular weight of this polyimide copolymer was measured by high performance liquid chromatography (commercial product of Tosoh Corporation), which is shown in Table 2.

The above-described polyimide copolymer solution (20% by weight) was flowed on a glass plate using a doctor knife, and the solution was dried at 90°C for 1 hour in an infrared drier. The obtained polyimide film was peeled off from the glass plate and clipped on a metal frame (12 cm x 17 cm), followed by heating the film at 200°C for 1 hour to dry it in an infrared drier. The thickness of this polyimide copolymer film was 40 to 50 $\mu$m. This polyimide copolymer film was cut into pieces with a size of about 10 mm x 10 mm, and the relative dielectric constant of the film was measured using HP4211A commercially available from Hewlett-Packard. The sample was sandwiched between electrodes on its upper and lower surfaces, and the frequency was changed from 1.8 GHz to 1 MHz, during which capacitance at 5 or 6 points was measured, thereby determining relative dielectric constant. The result of this measurement of the relative dielectric constant is shown in Table 2.

Preparation of Photoresist Composition

Fifteen grams aliquot of the polyimide copolymer solution (20% by weight) prepared by the method described above was taken (in this case, the content of the polyimide copolymer resin component was 3 g), and 0.45 g (15% by weight based on the polyimide resin) of NT-200 and 0.21 g (7% by weight based on the polyimide resin) of phenyl benzoate were added thereto. The obtained mixture is referred to as "mixture solution A". On the other hand, 15 g aliquot of the polyimide copolymer solution (20% by weight) prepared by the method described above was taken (in this case, the content of the polyimide copolymer resin component was 3 g), and 0.6 g (20% by weight based on the polyimide resin) of NT-200 was added thereto. The obtained mixture is referred to as "mixture solution B".

Each photoresist composition was applied on the surface of a surface-treated copper foil having a diameter of 5 cm (commercial product of Mitsui Metal and Mining Co., Ltd.: thickness 18 $\mu$m) by spin-coating method, and dried by an infrared dryer at 90°C for 10 minutes. The thickness of the photoresist film was about 10 $\mu$m.

On this photoresist coating film, a test pattern (through holes and line-and-space pattern having diameters and widths of 10, 15,20,25, ---, and 200 $\mu$m, respectively) for positive-type photomask was placed, and the photoresist film was irradiated at a dose of exposure at which images are obtained using 2 kW extra-high pressure mercury lamp apparatus (JP-2000G, commercial product of Oak Seisakusho). The coating films obtained from mixture solutions A and B were irradiated at a dose of exposure of 1000 mJ, and developed with a developer (the developer was a mixture of 30 g of aminoethanol, 30 g ofN-methylpyrrolidone and 30 g of water). The coating film obtained from mixture solution A was dipped in the developer at 40°C for 4 minutes and 10 seconds, and then at 33°C for 9 minutes and 10 seconds, and that obtained from mixture solution B was dipped in the developer at 28°C for 8 minutes. The samples were washed with deionized water and dried with an infrared lamp, followed by observation of the resolution. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 11

Polyimide copolymer was synthesized in the same manner as in Example 10.

To the flask, 44.43 g (0.1 mol) of 6FDA, 17.43 g (0.05 mol) of FDA, 1.6 g (0.02 mol) of pyridine, 1.0 g (0.01 mol) of valerolactone, 200 g of NMP and 30 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 25.93 g (0.05 mol) of HFBAPP, 137 g of NMP and 100 g of toluene were added. After stirring the mixture at room temperature for 1 hour under nitrogen atmosphere, the mixture was heated to 180°C and stirred at 180 rpm for 2 hours and 45 minutes. During the reactions, toluene-water azeotrope was removed.

The polymer resin concentration of the polyimide copolymer solution thus obtained was 20% by weight. The molecular weight distribution and the relative dielectric constant of this polyimide copolymer were measured, which are shown in Table 2.

Preparation of Photoresist Composition

Fifteen grams aliquot of the polyimide copolymer solution (20% by weight) prepared by the method described above was taken (in this case, the content of the polyimide copolymer resin component was 3 g), and 0.45 g (15% by weight based on the polyimide resin) of NT-200 and 0.21 g of phenyl benzoate were added thereto.

The photoresist composition was applied on the surface of a surface-treated copper foil having a diameter of 5 cm (commercial product of Mitsui Metal and Mining Co., Ltd.: thickness 18 μm) by spin-coating method, and dried by an infrared dryer at 90°C for 10 minutes. The thickness of the photoresist film was about 10 μm.

Using the same method as in Example 10, the photoresist film was irradiated at a dose of exposure at which images are obtained. A sample irradiated at a dose of exposure of 1000 mJ was developed with the developer used in Example 1. The sample was dipped in the developer at 50°C for 10 minutes and 30 seconds, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 12

Polyimide copolymer was synthesized in the same manner as in Example 10.

To the flask, 17.77 g (0.04 mol) of 6FDA, 20.91 g (0.06 mol) of FDA, 1.9 g (0.024 mol) of pyridine, 1.2 g (0,012 mol) of valerolactone, 147 g of NMP and 30 g of toluene were added. After stirring the mixture at room temperature for 1 hour at 180 rpm under nitrogen atmosphere, the mixture was heated to 180°C and stirred at 180 rpm for 1 hour. After cooling the mixture to room temperature, 22.54 g (0.08 mol) of BPDA, 16.84 g (0.02 mol) of diaminosiloxane, 40 g (0.04 mol) of 3,3'-dimethylbenzidine, 100 g of NMP and 50 g of toluene were added. After stirring the mixture at room temperature for 1 hour under nitrogen atmosphere, the mixture was heated to 180°C and stirred at 180 rpm for 3 hours and 45 minutes. During the reactions, toluene-water azeotrope was removed.

The polymer resin concentration of the polyimide copolymer solution thus obtained was 25% by weight. The molecular weight distribution and the relative dielectric constant of this polyimide copolymer were measured, which are shown in Table 2.

Preparation of Photoresist Composition

Twelve grams aliquot of the polyimide copolymer solution (25% by weight) prepared by the method described above was taken (in this case, the content of the polyimide copolymer resin component was 3 g), and 0.45 g (15% by weight based on the polyimide resin) of NT-200 was added thereto.

The photoresist composition was applied on the surface of a surface-treated copper foil having a diameter of 5 cm (commercial product of Mitsui Metal and Mining Co., Ltd.: thickness 18 μm) by spin-coating method, and dried by an infrared dryer at 90°C for 10 minutes. The thickness of the photoresist film was about 10 μm.

Using the same method as in Example 10, the photoresist film was irradiated at a dose of exposure at which images are obtained. A sample irradiated at a dose of exposure of 1000 mJ was developed with the developer (the developer was a mixture of 30 g of aminoethanol, 30 g of N-methylpyrrolidone and 30 g of water). The sample was dipped in the developer at 45°C for 10 minutes and 48 seconds, and washed with deionized water. The sample was dried with an infrared lamp and the resolution was observed. As for the through hole patterns in the polyimide copolymer coating film, formation of through holes having sharp and circular sections having a diameter of 15 μm was confirmed. As for the line-and-space pattern, formation of images of lines having a width of 15 μm was confirmed.

Example 13

Preparation of Low Dielectric Polyimide Substrate

On a glass plate, a glass cloth (commercial product of Nitto Boseki Co., Ltd., thickness: 173 μm) sizing 10 cm x 10 cm was placed, and the polyimide copolymer varnish obtained in Example 1 was applied thereon with a coater. The coated composition was heated to dry at 90°C for 1 hour in an infrared drier. The glass cloth was then turned over, and the polyimide copolymer varnish obtained in Example 1 was again applied thereon with a coater. The coated composition was heated to dry at 90°C for 1 hour in an infrared drier. The resultant was heated to dry at 150°C for 2 hours in a vacuum drier to obtain a polyimide copolymer prepreg. The overall thickness of the substrate was 250 μm.

A polyimide adhesive was prepared in accordance with the method described in Japanese Laid-open Patent Application (Kokai) No. 6-41507. To 5 g of polyimide copolymer powder synthesized from bicyclo-(2,2,2)-oct-7-ene-2,3,5,6-tetracarboxylic dianhydride, 3,3',4,4'-benzophenonetetracarboxylic dianhydride and 4,4'-bis{(3-aminophenoxy)phenyl}sulfone, 20 g of NMP was added and the polyimide was dissolved at 85°C. Then 1 g of bis(4-maleimidephenyl)methane was added and dissolved at room temperature to obtain a polyimide adhesive varnish.

On a copper foil (18 μm, surface-treated) commercially available from Mitsui Metal and Mining Co., Ltd., the polyimide adhesive varnish was applied, and dried at 90°C for 2 hours in an infrared drier. The obtained adhesive polyimide-coated copper foil was cut into a piece sizing 5 cm x 5 cm, and this piece was adhered with the above-described prepreg under heat at 230°C and at 50 kg/cm$^2$. The adhesion strength of the copper foil on the copper-foil laminated substrate measured by a peeling test in a direction of 180° was 1.5 kg/cm.

Table 1-(1)

| Molecular Weight Distribution of Polyimide Copolymers | | | | | | | |
|---|---|---|---|---|---|---|---|
| Example | Experiment No. | Molecular Weight Distribution | | | | | |
| | | M | Mn | Mw | Mz | Mw/Mn | Mz/Mw |
| 1 | 19-194 | 64400 | 32800 | 75500 | 139400 | 2.30 | 4.22 |
| 2 | 18-111 | 56000 | 28700 | 63600 | 115400 | 2.21 | 4.02 |
| 3 | 19-92 | 34500 | 18400 | 34700 | 55800 | 1.89 | 3.04 |
| 4 | 19-91 | 43800 | 23800 | 46300 | 75600 | 1.95 | 3.18 |
| 5 | 17-79 | 37600 | 24100 | 41000 | 63400 | 1.70 | 2.65 |
| 6 | 17-78 | 40400 | 29800 | 48500 | 75900 | 1.63 | 2.55 |
| 7 | 17-77 | 46800 | 30000 | 51400 | 80400 | 1.71 | 2.68 |
| 8 | 20-12 | 91000 | 46200 | 244600 | 727600 | 5.29 | 15.7 |
| 9 | 18-108 | 25600 | 14000 | 25600 | 46100 | 1.83 | 2.66 |

Table 1-(2)

| Results of Measurement of Relative Dielectric Constants of Polyimide Copolymers | | | |
|---|---|---|---|
| Example | Experiment No. | Thickness of Polyimide Film (μm) | Relative Dielectric Constant (at 100 MHz) |
| 1 | 19-194 | 31 | 2.62 |
| 2 | 18-111 | 40 | 2.56 |
| 3 | 19-92 | 42 | 2.60 |
| 4 | 19-91 | 55 | 2.49 |
| 5 | 17-79 | 42 | 2.61 |
| 6 | 17-78 | 46 | 2.65 |
| 7 | 17-77 | 53 | 2.60 |
| 8 | 20-12 | 43 | 2.71 |
| 9 | 18-108 | 24 | 2.90 |

In Table 1, M: most frequent molecular weight; Mn: number average molecular weight, Mw: weight average molecular weight, Mz: z average molecular weight. The relative dielectric constants shown are results of measurement at 100 MHz.

Table 2

| Molecular Weight Distribution of Polyimide Copolymers | | | | | | | |
|---|---|---|---|---|---|---|---|
| Example | Experiment No. | Molecular Weight Distribution | | | | | |
| | | M | Mn | Mw | Mz | Mw/Mn | Mz/Mw |
| 10 | 17-52 | 46400 | 28500 | 51300 | 81900 | 1.80 | 2.87 |
| 11 | 17.50 | 49200 | 31800 | 51900 | 77700 | 1.53 | 2.44 |
| 12 | 18-151 | 28000 | 14900 | 28000 | 45000 | 1.87 | 3.02 |

Table 2

| Results of Measurement of Relative Dielectric Constants of Polyimide Copolymers | | | |
|---|---|---|---|
| Example | Experiment No. | Thickness of Polyimide Film ($\mu$m) | Relative Dielectric Constant (at 100 MHz) |
| 10 | 17-52 | 46 | 2.62 |
| 11 | 17-50 | 50 | 2.64 |
| 12 | 18-151 | 37 | 2.72 |

In Table 1, M: most frequent molecular weight, Mn: number average molecular weight, Mw: weight average molecular weight, Mz: z average molecular weight. The relative dielectric constants shown are results of measurement at 100 MHz.

## Claims

1. A photosensitive, low dielectric polyimide which shows positive-type photosensitivity, which is soluble in a solvent, which is formed by polycondensation between one or more aromatic tetracarboxylic dianhydrides and mainly one or more aromatic diamines, at least one of said one or more aromatic tetracarboxylic dianhydrides and said one or more diamines containing (a) fluorine atom(s), and/or said diamine(s) being benzidine or (a) derivative(s) thereof and/or (a) fluorene derivative(s), which polyimide has a relative dielectric constant of not more than 2.90.

2. The polyimide according to claim 1, which has a relative dielectric constant of not more than 2.70.

3. The polyimide according to claim 1 or 2, wherein said fluorene derivative is 9,9-bis(4-aminophenyl)fluorene, said benzidine derivative is 3,3'-dimethylbenzidine, and said polyimide contains at least one of these aromatic diamines.

4. The polyimide according to any one of claims 1 to 3, which is a polyimide copolymer that contains not less than two diamine components.

5. The polyimide according to claim 4, which is a polyimide block copolymer.

6. The polyimide according to claim 4 or 5, which is a polyimide copolymer comprising a diamine and/or an aromatic tetracarboxylic dianhydride containing (a) fluorine atom(s), 9,9-bis(4-aminophenyl)fluorene and 3,3'-dimethylbenzidine.

7. The polyimide according to any one of claims 1 to 6, further comprising a diaminosiloxane as a diamine component.

8. The polyimide according to any one of claims 3 to 7, which comprises one or more aromatic diamines selected from the group consisting of 2,2-bis{4-(4-aminophenoxy)phenyl}hexafluoropropane, 3,4'- or 4,4'-diaminodiphenylether, 3,3'-dihydroxybenzidine and 3,5-diaminobenzoic acid.

9. The polyimide according to any one of claims 1 to 8, which is a polyimide copolymer wherein said aromatic tetracarboxylic dianhydrides are mainly 4,4'-{2,2,2-trifluoro-1 (trifluoromethyl)ethylidene} bis ( 1,2-benzenedicarboxylic anhydride), and 3,4,3',4'-biphenyltetracarboxylic dianhydride and/or 3,4,3',4'-benzophenonetetracarboxylic dianhydride.

10. The polyimide according to claim 9, which is a block polyimide copolymer.

11. The polyimide according to any one of claims 1 to 10, which is obtained by heating and dehydrating said tetracarboxylic dianhydride(s) and said diamine(s) in the presence of a composite catalyst consisting essentially of a lactone and a base, at a temperature of 150 to 220°C in a polar solvent.

12. The polyimide according to claim 11, wherein said polyimide is a block copolymer having a molar ratio of total aromatic diamines to total tetracarboxylic anhydrides of 1.05 to 0.95, which is obtained by reacting a first tetracarboxylic dianhydride and a first diamine in the presence of a composite catalyst consisting essentially of a lactone and a base to obtain an imide oligomer, and then adding and reacting a second tetracarboxylic dianhydride and/ or a second diamine.

13. The polyimide according to any one of claims 1 to 12, wherein said polyimide has an average molecular weight in terms of polystyrene of 30,000 to 400,000.

14. A printed board comprising said polyimide according to any one of claims 1 to 14, which polyimide is impregnated in glass fibers or Kevler woven fabric and dried to solidify.

15. A positive-type photosensitive, low dielectric polyimide composition comprising said polyimide according to any one of claims 1 to 13, and a photoacid generator.

16. The composition according to claim 15, further comprising at least one selected from the group consisting of isopropyl benzoate, t-butyl benzoate and phenyl benzoate as (a) photosensitizer(s).

17. A method for preparing a positive-type pattern of polyimide film, comprising adding a photoacid generator to the polyimide according to any one of claims 1 to 13, applying the obtained composition on a substrate, irradiating an active light source in a patterned shape, and removing the irradiated regions by development.

18. The method according to claim 17, wherein isopropyl benzoate, t-butyl benzoate and/or phenyl benzoate is(are) used as (a) photosensitizer(s).

19. The method according to claim 17 or 18, wherein the developing solution used in said development is an alkaline solution.

20. The method according to claim 19. wherein said alkaline solution contains aminoethanol.

21. The patterned polyimide film formed by the method according to any one of claims 17 to 20.

22. Use of the polyimide film according to claim 21 as a low dielectric insulation film.

## INTERNATIONAL SEARCH REPORT

| | International application No. |
|---|---|
| | PCT/JP00/04173 |

**A. CLASSIFICATION OF SUBJECT MATTER**
  Int.Cl⁷   C08G73/10, G03F7/037

According to International Patent Classification (IPC) or to both national classification and IPC

**B. FIELDS SEARCHED**

Minimum documentation searched (classification system followed by classification symbols)
  Int.Cl⁷   C08G73/10, G03F7/037

Documentation searched other than minimum documentation to the extent that such documents are included in the fields searched

Electronic data base consulted during the international search (name of data base and, where practicable, search terms used)
   CA(STN)

**C. DOCUMENTS CONSIDERED TO BE RELEVANT**

| Category* | Citation of document, with indication, where appropriate, of the relevant passages | Relevant to claim No. |
|---|---|---|
| P,X<br><br>P,A | JP, 11-231531, A (Hitachi Chemical Co., Ltd.),<br>27 August, 1999 (27.08.99)  (Family: none) | 1,4,13,15,<br>17,19,21-22<br>2-3,5-12,14,16<br>,18,20 |
| P,X<br><br>P,A | JP, 11-231532, A (Hitachi Chemical Co., Ltd.),<br>27 August, 1999 (27.08.99)  (Family: none) | 1,4,7,13,15,19<br>,21-22<br>2-3,5-6,<br>8-12,14,<br>16-18,20 |
| X<br><br>A | JP, 11-125909, A (Hitachi Chemical Co., Ltd.),<br>11 May, 1999 (11.05.99)  (Family: none) | 1,4,7,13,15,17<br>,19,21-22<br>2-3,5-6,<br>8-12,14,16,<br>18,20 |
| X<br><br>A | JP, 11-35684, A (Hitachi Chemical Co., Ltd.),<br>09 February, 1999 (09.02.99)  (Family: none) | 1,7,13,15,<br>17,19,21-22<br>2-6,8-12,14,16<br>,18,20 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 07 September, 2000 (07.09.00) | 19 September, 2000 (19.09.00) |

| Name and mailing address of the ISA/ | Authorized officer |
|---|---|
| Japanese Patent Office | |
| Facsimile No. | Telephone No. |

Form PCT/ISA/210 (second sheet) (July 1992)